# EUROPEAN PATENT APPLICATION

(11) **EP 2 887 389 A1**
(43) Date of publication of application: **24.06.2015**
(21) Application number: 13197850.4
(22) Date of filing: 17.12.2013
(51) Int. Cl.: H01L 23/04, H01L 23/047, H01L 21/50

(54) **A precursor to a packaged electronic component**

(71) Applicant: NXP B.V., 5656 AG Eindhoven (NL)
(72) Inventor: Cheng, Philip Cruz, Redhill, Surrey RH1 1SH (GB)
(74) Representative: Crawford, Andrew

(57) **Abstract**

A precursor to a packaged electronic component, the precursor comprising: a heat conductor (302) comprising two or more component regions (309) to which electronic components (301) can be attached; and a ring frame (303) comprising two or more apertures (310) and a separation region (311) located between adjacent apertures (310), wherein the ring frame (303) is attached to the heat conductor (302) such that each aperture (310) is positioned over a respective component region (309), and wherein the separation region (311) is configured to allow the precursor to be separated into two or more discrete electronic component packages (312) each comprising a respective component region (309) having one or more electronic components (301) attached thereto.

## Description

The present disclosure relates to the packaging of electronic components, and in particular to a precursor which can be used to form two or more discrete electronic component packages.

Packaging electronic components can involve attaching the electronic components to a heat conductor using a die attach process. Die attach processes typically require the application of heat to attach the electronic components to the heat conductor which can cause damage to other parts of the electronic package, in particular a ring frame.

There is described herein an apparatus and associated method which can reduce the likelihood of damage to the ring frame of an electronic package during attachment of one or more electronic components.

According to a first aspect, there is provided a precursor to a packaged electronic component, the precursor comprising:
a heat conductor comprising two or more component regions to which electronic components can be attached; and
a ring frame comprising two or more apertures and a separation region located between adjacent apertures, wherein the ring frame is attached to the heat conductor such that each aperture is positioned over a respective component region, and wherein the separation region is configured to allow the precursor to be separated into two or more discrete electronic component packages comprising a respective component region having one or more electronic components attached thereto.

The configuration of the precursor has been found to reduce the likelihood of damage to the ring frame during attachment of one or more electronic components to the heat conductor. In addition, it may enable an improvement in the efficiency of the packaging process resulting in a corresponding increase in the total number of packaged electronic components per unit time.

The term *"heat conductor"* as used herein includes a flange as used in current electronic packages. Furthermore, the heat conductor may or may not be configured to conduct electricity as well as heat.

Separation of the precursor into the two or more discrete electronic component packages may be referred to as singulation or depanelling.

The component regions of the heat conductor may be arranged in a line, optionally a straight line. The component regions of the heat conductor may be arranged in a grid/array.

The separation region may be structurally weakened to facilitate separation of the precursor into the two or more discrete electronic component packages. The precursor may comprise a marking (e.g. scribe line) at the separation region to guide separation of the precursor into the two or more discrete electronic component packages.

The two or more component regions may be different regions of a continuous heat conductor. The continuous heat conductor may comprise a structurally weakened separation region which is substantially aligned with the structurally weakened separation region of the overlying ring frame. The two or more component regions may be formed from discrete parts of a discontinuous heat conductor. The discrete parts may be separated by a break in the discontinuous heat conductor located beneath the structurally weakened separation region of the overlying ring frame.

The separation region may extend transversely across the ring frame. The separation region may extend from one edge of the ring frame to another.

The precursor may comprise two or more pairs of input and output leads. Each pair of input and output leads may be attached to the ring frame adjacent a respective component region to enable an electrical connection to be made between the component region and a circuit board.

The precursor may comprise one or more electronic components attached to each component region of the heat conductor. Each of the one or more electronic components may be electrically connected to the input and output leads of the respective component regions by wires. The one or more electronic components attached to each component region of the heat conductor may comprise at least one of a transistor and a capacitor. The transistor may be a laterally diffused metal oxide semiconductor transistor.

The precursor may comprise a lid attached to the ring frame at each component region to seal the one or more electronic components attached to the respective component regions within the precursor. Each lid may comprise a marking to identify the one or more electronic components attached to the respective component region.

The ring frame may comprise a ceramic. The ceramic may comprise aluminium oxide. The heat conductor may comprise a metal. The metal may comprise copper. The lids may comprise one or more of a ceramic, glass or metal. The wires may comprise one or more of gold, aluminium, copper and silver.

According to a further aspect, there is provided a method of packaging electronic components, the method comprising:
attaching one or more electronic components to each of two or more component regions of a heat conductor of a precursor to a packaged electronic component, the precursor further comprising a ring frame having two or more apertures and a separation region located between adjacent apertures, wherein the ring frame is attached to the heat conductor such that each aperture is positioned over a respective component region; and
separating the precursor at the separation region to form two or more discrete electronic component packages each comprising a respective component region having one or more electronic components attached thereto.

The method may comprise attaching the one or more electronic components to the respective component regions using one or more of adhesive die attach and eutectic die attach.

The method may comprise attaching two or more pairs of input and output leads to the ring frame such that each pair of input and output leads is positioned adjacent a respective component region to enable an electrical connection to be made between the component region and a circuit board. The method may comprise attaching the input and output leads to the ring frame using soldering.

The method may comprise attaching wires between each electronic component and the input and output leads of the respective component region to enable an electrical connection to be made between the electronic component and the circuit board. The method may comprise attaching the wires between the electronic components and the input and output leads using one or more of ball bonding, wedge bonding and compliant bonding.

The method may comprise attaching lids to the ring frame at each component region to seal the one or more electronic components attached to the respective component regions within the precursor. The method may comprise attaching the lids to the ring frame using one or more of solder sealing, glass sealing, brazing and welding.

The method may comprise applying a marking to each lid to identify the one or more electronic components attached to the respective component region.

The method may comprise testing the precursor for sealing leaks after the lids have been attached to the ring frame. The method may comprise testing the precursor for sealing leaks using one or more of bubble leak testing and mass spectroscopy leak testing.

The method may comprise performing one or more of the lead attachment, wire attachment, sealing, marking, and leak testing steps before the precursor has been separated into the one or more discrete electronic component packages. The method may comprise performing one or more of the component attachment, lead attachment, wire attachment, sealing, marking and leak testing steps one component region at a time. The method may comprise performing one or more of the component attachment, lead attachment, wire attachment, sealing, marking and leak testing steps on two or more component regions at the same time. The two or more component regions may be spaced apart from each other, that is not adjacent to each other.

The method may comprise performing one or more of the lead attachment, wire attachment, sealing, leak testing and marking steps after the precursor has been separated into the one or more discrete electronic component packages.

The method may comprise separating the precursor into one or more discrete electronic component packages using one or more of breaking, cutting, punching, routing, sawing and lasing.

The steps of any method disclosed herein do not have to be performed in the exact order disclosed, unless explicitly stated or understood by the skilled person.

Corresponding computer programs for implementing one or more steps of the methods disclosed herein are also within the scope of the present disclosure and are encompassed by one or more of the described example embodiments.

One or more of the computer programs may, when run on a computer, cause the computer to configure any apparatus, including a circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

Throughout the present specification, descriptors relating to relative orientation and position, such as "over", "under", "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed invention.

A description is now given, by way of example only, with reference to the accompanying drawings, in which:-
Figure 1 illustrates schematically a packaged electronic component (cross-section);
Figure 2 illustrates schematically cracks in the ring frame of an electronic package caused by the application of heat during attachment of an electronic component (plan view);
Figure 3a illustrates schematically a precursor to a packaged electronic component (plan view);
Figure 3b illustrates schematically another precursor to a packaged electronic component (plan view);
Figure 4a illustrates schematically a further precursor to a packaged electronic component (cross-section);
Figure 4b illustrates schematically a further still precursor to a packaged electronic component (cross-section);
Figure 5a illustrates schematically the precursor of Figure 3a comprising electronic components connected to input/output leads by wires (plan view);
Figure 5b illustrates schematically the precursor of Figure 5a comprising lids for sealing the electronic components therein (plan view);
Figure 5c illustrates schematically discrete electronic component packages formed by separating the precursor of Figure 5b at structurally weakened separation regions (plan view); and
Figure 6 illustrates schematically a method of packaging electronic components.

Later examples depicted in the figures have been provided with reference numerals that correspond to similar features of earlier described examples. For example, feature number 1 can also correspond to numbers 101, 201, 301 etc. These numbered features may appear in the figures but may not be directly referred to within the description of these particular examples. This has been done to aid understanding, particularly in relation to the features of similar earlier described examples.

An electronic component package is a casing for one or more electronic components of a device. The electronic components are typically fabricated before being assembled in the package. The package provides protection against impact and corrosion, holds the contact pins or leads which are used to connect the electronic components to external circuits, and dissipates heat produced during operation of the device. The package also provides mechanical support to the electronic components making handling easier during device assembly.

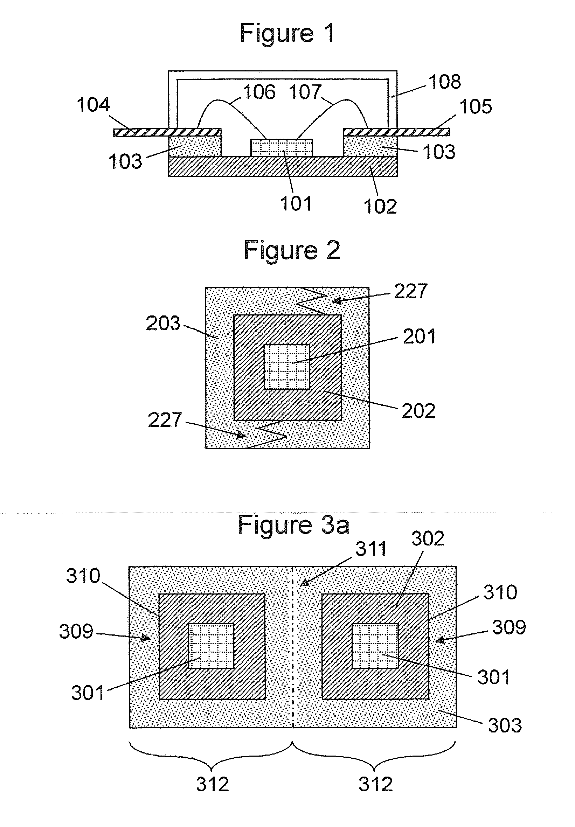

Figure 1 shows one example of a packaged electronic component in cross-section. In this example, the electronic component 101 is contained within an air cavity package, but other types of package may be used instead, such as an over-moulded package. The air cavity package comprises a heat conductor 102 to which the electronic component 101 is attached. The heat conductor 102 may also be known as a flange. The heat conductor 102 is used to support the electronic component 101 and dissipate heat generated during its attachment and operation to the surrounding environment. Some printed circuit board (PCBs) also comprise a heat sink for dissipating heat. In this scenario, the heat conductor 102 may be attached to the heat sink to facilitate heat dissipation.

The package in Figure 1 also comprises a ring frame 103 attached to the upper surface of the heat conductor 102. Depending on the materials used for the ring frame 103 and heat conductor 102, the ring frame 103 may be glued or soldered to the heat conductor 102. The ring frame 103 is used to support the input lead 104 and output lead 105 that provide an externally accessible electrical connection to the electronic component 101. A first end of each of the leads 104, 105 may be glued or soldered to the ring frame 103 depending on the materials from which they are made. A second end of each of the leads 104, 105 may be soldered to a PCB. The electronic component 101 is electrically connected to the input lead 104 and output lead 105 by respective wires 106, 107 which are bonded to the electronic component 101 and leads 104, 105 using one or more of heat, pressure and ultrasonic energy.

As can be seen in Figure 1, the electronic package also comprises a lid 108 to complete encapsulation of the electronic component 101. The lid 108 is attached to the ring frame 103 using a sealing, brazing or welding process to form a hermetic seal. Again, the process used to form the seal is dependent upon the materials used to form the lid 108 and ring frame 103.

As mentioned above, die attach processes are commonly used to attach the electronic component 101 to the heat conductor 102. One such process is adhesive die attach, which involves the use of an adhesive such as polyimide, epoxy or silver-filled glass to mount the electronic component 101 on the heat conductor 102. Once the electronic component 101 is correctly positioned on top of the adhesive, the adhesive is cured to form a secure bond between the electronic component 101 and heat conductor 102.

Another die attach process is eutectic die attach, which uses a eutectic alloy such as gold-silicon to mount the electronic component 101 on the heat conductor 102. For die attach using a gold-silicon eutectic alloy, a gold preform is placed on top of the heat conductor 102 and the package is heated. When the electronic component 101 is mounted on top of the gold preform, silicon from the electronic component 101 diffuses into the gold preform forming a gold-silicon alloy. As more silicon diffuses into the gold preform, the silicon-to-gold ratio of the alloy increases until such time as the "eutectic ratio" is achieved. The eutectic ratio is the ratio with the lowest melting point for that particular alloy. The gold-silicon eutectic alloy comprises 2.85% of silicon and melts at about 363°C. When the temperature exceeds the eutectic melting point, the alloy melts attaching the electronic component 101 to the heat conductor 102. Eventually the diffusion of silicon atoms into the gold preform exceeds the eutectic limit and the die attach alloy begins to solidify once again. The package is then allowed to cool down to fully solidify the eutectic alloy and complete the die attach process.

Figure 2 shows a ceramic package in plan view comprising a ceramic ring frame 203 and a heat conductor 202 with an electronic component 201 attached thereto. The above-mentioned die attach processes each require the application of heat which can cause damage to the ring frame 203. This is because the ring frame 203 is positioned directly on top of the heat conductor 202 and is therefore exposed to thermal energy from the heat conductor 202. When ceramic ring frames 203 are used, some of this heat dissipates via the ceramic and can create cracks 227 in the ceramic, as shown in Figure 2. This can potentially result in failure of the packaged electronic component. Similar thermal effects may also be experienced with ring frames 203 made from other materials.

The apparatus and associated method described below may address issues relating to potentially damaging thermal effects on a ring frame.

Figure 3a shows a precursor to a packaged electronic component according to one example of the present disclosure. The precursor comprises a heat conductor 302 having a plurality of component regions 309 (in this case two) to which electronic components 301 can be attached as described above. The precursor also comprises a ring frame 303 having a plurality of apertures 310, and a separation region 311 located between adjacent apertures 310. The ring frame 303 is attached to the heat conductor 302 such that each aperture 310 is positioned over a respective component region 309 and a component 301 on the component region 309 is accessible through the aperture 310.

The separation region 311 allows the precursor to be separated into two or more discrete electronic component packages 312; each discrete electronic package 312 comprising a component region 309 having one or more electronic component 301 attached thereto. In this example, the separation region 311 extends transversely across the ring frame from one edge to another. This may be useful if the precursor is to be broken into the discrete packages rather than be cut, punched, routed, sawn or lased (described later). The ring frame 303 may comprise a ceramic, metal or plastic, and the heat conductor 302 may comprise metal. For example, the ring frame 303 may comprise aluminium oxide and the heat conductor 302 may comprise copper.

The configuration of the precursor enables the electronic components 301 for multiple devices to be packaged in parallel. This may result in an improvement in the efficiency of the packaging process and a greater throughput of packaged electronic components. Importantly, the configuration of the precursor also advantageously reduces the likelihood of damage to the ring frame 303 during attachment of the electronic components 301 to the heat conductor 302. This is because the heat generated during attachment of the electronic components 301 to one component region 309 is dissipated by the ring frame material 303 surrounding several component regions 309. By distributing the heat through a greater volume of ring frame material, the dissipated heat is less likely to crack the ring frame 303. Furthermore, the extra volume of the ring frame material that will not form part of the final discrete electronic package 312 will not be wasted, as it will form part of a different final discrete electronic package 312.

It has been found that the precursor can be used to increase the packaging throughput by at least 30% relative to existing packaging processes. For example, this may be used to increase the number of packages from 6000 pieces per day to 8000 pieces per day. Furthermore, tests performed using an aluminium oxide ring frame 303 and a continuous copper heat conductor 302 have shown that the ring frame 303 can withstand die attach temperatures of up to 430°C without cracking. This is because the rate of cooling between the alumina ceramic and the copper is slowed down by the increase in size of the ring frame 303 which reduces the thermal stress acting thereon.

Any number of electronic components 301 may be attached to each component region 309 of the heat conductor 302, although the absolute number will typically be limited by the area of the component region 309 as well as the size and shape of the PCB and device. Furthermore, the precursor described herein is not limited to use with any particular electronic components 301, although possible examples include radio frequency capacitors and transistors (such as laterally diffused metal oxide semiconductor transistors) for base station, broadcast and microwave applications.

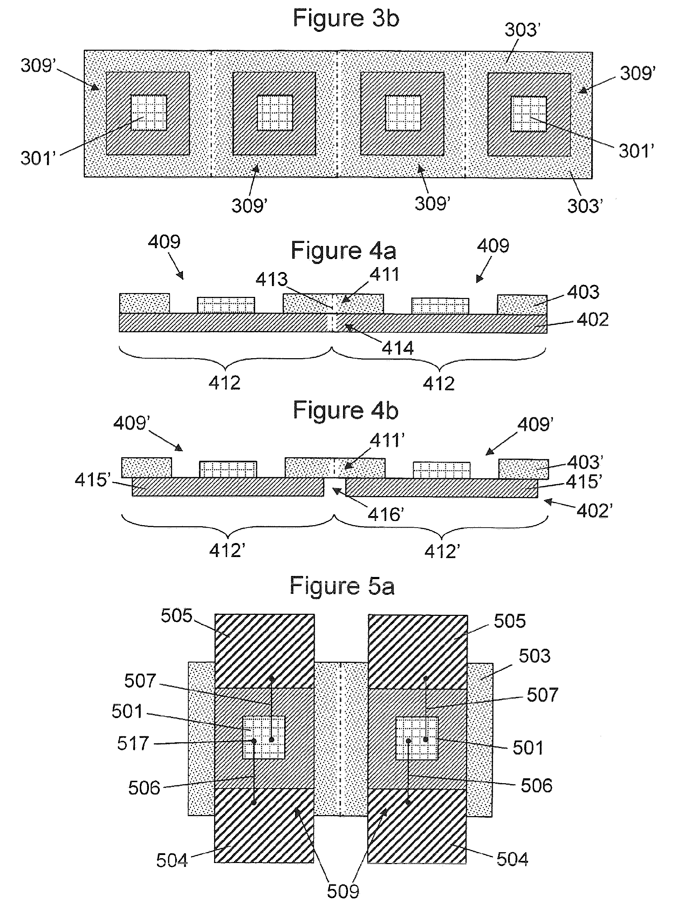

Figure 3b shows a precursor according to another example of the present disclosure. This example is similar to that shown in Figure 3a, only this time the precursor comprises four component regions 309' rather than two. Although the component regions 309' are arranged in a straight line in this example, they could be arranged in a grid/array instead. By increasing the number of component regions 309', an even greater number of electronic components 301' can be packaged in parallel, and the impact of the dissipated heat on the ring frame structure 303' is further reduced. It should be noted, however, that the precursor is not limited to two or four component regions. In theory, the concept could be extended to any number of component regions, although in practice this may be limited by the manufacturing equipment used during the packaging process.

In some examples, attachment of the electronic components 301' is not performed for all component regions 309' at the same time. This can increase the effect of the improved heat dissipation. In this respect, it may be advantageous to attach the one or more electronic components 301' to their respective component regions 309' one component region 309' at a time. Alternatively, a plurality of non-adjacent electric components 301' may be attached simultaneously. The complete packaging process comprises several steps which are discussed below, and the parallel processing associated with the present apparatus may be used to increase efficiency at some or all of the steps.

Figure 4a shows the precursor of Figure 3a in cross-section. In this example, the separation region 411 of the ring frame 403 is structurally weakened to facilitate separation of the precursor into two discrete electronic packages 412. The ring frame 403 also comprises a scribe line 413 to indicate the location of the structurally weakened separation region 411. In addition, the component regions 409 are different regions of a continuous heat conductor 402. The continuous heat conductor 402 also comprises a structurally weakened separation region 414 which is substantially aligned with the structurally weakened separation region 411 of the overlying ring frame 403. In this example, therefore, the precursor can be separated into two discrete electronic packages 412 simply by breaking the apparatus at the structurally weakened separation region 411, 414. This may be performed manually by hand, or by using a machine.

Figure 4b shows another example of a precursor in cross-section. As with the example shown in Figure 4a, the separation region 411 of the ring frame 403 is structurally weakened to facilitate separation of the precursor into two discrete electronic packages 412. In this example, however, the component regions 409 are formed from discrete parts 415 of a discontinuous heat conductor 402. The discrete parts 415 are separated by a break 416 in the discontinuous heat conductor 402 located beneath the structurally weakened separation region 411 of the overlying ring frame 403. This configuration also allows the precursor to be separated into discrete electronic packages 412 by breaking the apparatus at the structurally weakened separation region 411 of the ring frame 403. Unlike the example shown in Figure 4a, however, there is no need to incorporate a structurally weakened separation region 414 into the heat conductor 402. That said, a discontinuous heat conductor 402 may need to be formed on a supporting substrate which could be removed (e.g. by wet or dry chemical etching, dissolution or sublimation) after attachment of the ring frame 403.

Figure 5a shows the precursor of Figure 3a (in plan view) further comprising two pairs of input leads 504 and output leads 505, and also wires 506, 507 which electrically connect the electronic components 501 to the input 504 and output 505 leads. Each pair of input leads 504 and output leads 505 are attached to the ring frame 503 at a position that is adjacent to a respective component region 509 in order to enable an electrical connection to be made between the electronic components 501 of the component region 509 and a PCB. The input leads 504 and output leads 505 may be attached to the ring frame 503 by soldering. The wires 506, 507 may be attached between the electronic components 501 and the input/output leads 504, 505 using one or more of ball bonding, wedge bonding and compliant bonding. Ball bonding has been used to attach the wires 506, 507 shown in Figure 5a, as indicated by the shape of the bonds 517. A variety of different metals could be used to form the wires 506, 507, such as gold, aluminium, copper, silver and alloys thereof.

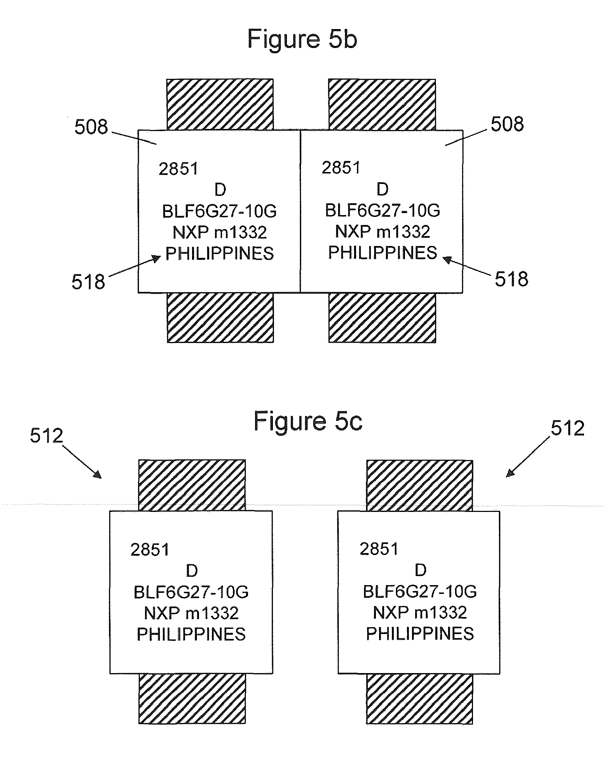

Figure 5b shows the precursor of Figure 5a (in plan view) further comprising a lid 508 attached to the ring frame at each component region 509. The lids 508 are used to seal the electronic components (not visible in figure 5b) attached to the respective component regions within the precursor. As shown in this figure, each lid 508 may comprise a marking 518 to identify the one or more electronic components 501 that are underneath the lid 508.. The lids 508 may be attached to the ring frame using a variety of different processes depending on the materials from which the lids 508 and ring frame are made. For example, if the lids 508 and ring frame comprise ceramic materials, the lids 508 can be sealed to the ring frame by solder sealing. If, however, the lids 508 or ring frame comprise glass, then a glass sealing process may be used instead. Furthermore, if both the lids 508 and ring frame comprise metals, then they may be sealed together by brazing or welding.

It should be noted that the electrical connections formed by the wires between each electronic component and the input lead and output lead of the respective component region would typically be tested before the lids 508 are attached to the ring frame. In addition, the precursor would typically be tested for sealing leaks after the lids 508 have been attached. This step may be performed using one or more of bubble leak testing and mass spectroscopy leak testing.

Figure 5c shows the precursor of Figure 5b (in plan view) after the precursor has been separated at the separation region into discrete electronic packages 512. The separation process may involve breaking, cutting, punching, routing, sawing or lasing the apparatus, although the ring frame (and possibly also the heat conductor) may benefit from a structurally weakened separation region if the precursor is to be broken, cut or sawn. Furthermore, the ring frame and/or heat conductor may comprise markings to guide the associated separation tool.

The discrete electronic packages 512 may be structurally and functionally similar to those produced using existing methods, but with a reduced chance of failure due to the presence of more ring frame material during attachment of the electronic components to the heat conductor. As discussed above, the increased volume of ring frame material can provide better thermal dissipation during one or more device construction processing steps.

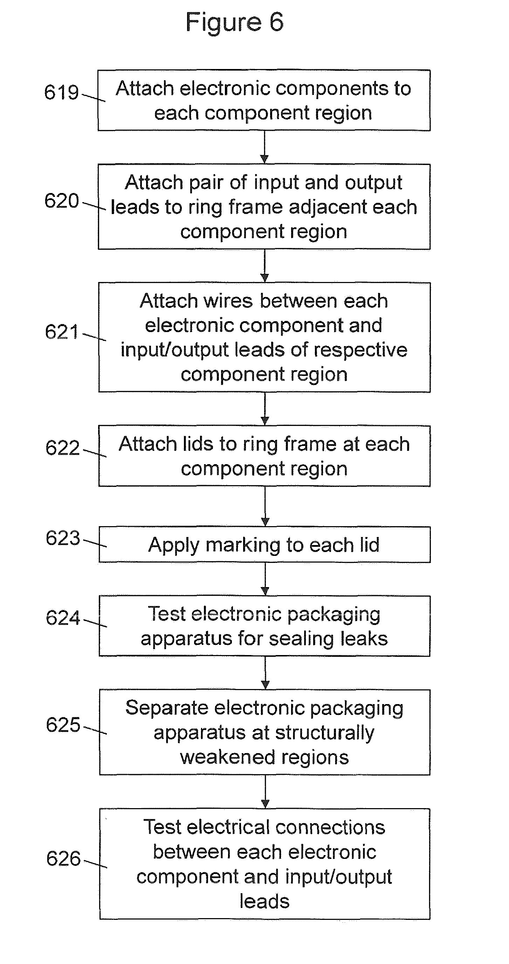

Figure 6 shows the main steps 619-626 of a method of packaging electronic components using the precursor described herein. The method comprises attaching 619 one or more electronic components to each component region of the apparatus, and attaching 620 a pair of input and output leads to the ring frame adjacent each component region. Although Figure 6 shows attachment 619 of the electronic components before attachment 620 of the input/output leads, the order of these steps 619, 620 could be reversed.

After the electronic components and input/output leads have been attached 619, 620, the method continues with attaching 621 wires between each electronic component and the leads of the respective component region.

The method continues with attaching 622 lids to the ring frame at each component region to hermetically encapsulate the electronic components. The method then involves applying 623 markings to each lid to identify the electronic components attached to the respective component region, and checking 624 the precursor for sealing leaks (and addressing any identified leaks). This marking step 623 could be performed either before or after the lids have been attached 622 to the ring frame and before or after checking 624 the precursor for sealing leaks.

The method continues with separating 625 the precursor at the separation regions into discrete electronic packages.

The method may comprise testing 626 the electrical connections between each electronic component and the input and output leads of the respective component region in order to identify any faults, such as short or open circuits.

Importantly, any of the lead attachment 620, wire attachment 621, electrical testing 626, sealing 622, leak testing 624 and marking 623 steps may be performed before or after the precursor has been separated 626 into the discrete packages. For greater packaging efficiency, as many of these steps 620-624 as possible may be performed before separation 625. If one or more of the lead attachment 620, wire attachment 621 and sealing 622 steps are to be performed before the precursor has been separated 625, however, it may be advantageous to perform them one component region at a time rather than all simultaneously in parallel. This is because these steps 620, 621, 622 typically involve the application of heat which will need to be dissipated from the apparatus. Therefore, if the component regions are processed sequentially, any heat generated during the various steps 620, 621, 622 can be more effectively dissipated using a greater volume of ring frame material.

## Claims

1. A precursor to a packaged electronic component, the precursor comprising:
a heat conductor comprising two or more component regions to which electronic components can be attached; and
a ring frame comprising two or more apertures and a separation region located between adjacent apertures, wherein the ring frame is attached to the heat conductor such that each aperture is positioned over a respective component region, and wherein the separation region is configured to allow the precursor to be separated into two or more discrete electronic component packages each comprising a respective component region having one or more electronic components attached thereto.

2. The precursor of claim 1, wherein the separation region is structurally weakened to facilitate separation of the precursor into the two or more discrete electronic component packages.

3. The precursor of claim 2, wherein the two or more component regions are different regions of a continuous heat conductor, and wherein the continuous heat conductor comprises a structurally weakened separation region which is substantially aligned with the structurally weakened separation region of the overlying ring frame.

4. The precursor of claim 2, wherein the two or more component regions are formed from discrete parts of a discontinuous heat conductor, and wherein the discrete parts are separated by a break in the discontinuous heat conductor located beneath the structurally weakened separation region of the overlying ring frame.

5. The precursor of any preceding claim, wherein the precursor comprises a marking at the separation region to guide separation of the precursor into the two or more discrete electronic component packages.

6. A method of packaging electronic components, the method comprising:
attaching one or more electronic components to each of two or more component regions of a heat conductor of a precursor to a packaged electronic component, the precursor further comprising a ring frame having two or more apertures and a separation region located between adjacent apertures, wherein the ring frame is attached to the heat conductor such that each aperture is positioned over a respective component region; and
separating the precursor at the separation region to form two or more discrete electronic component packages each comprising a respective component region having one or more electronic components attached thereto.

7. The method of claim 6, wherein the method comprises attaching two or more pairs of input and output leads to the ring frame such that each pair of input and output leads is positioned adjacent a respective component region to enable an electrical connection to be made between the component region and a circuit board.

8. The method of claim 7, wherein the method comprises attaching wires between each electronic component and the input and output leads of the respective component region to enable an electrical connection to be made between the electronic component and the circuit board.

9. The method of claim 8, wherein the method comprises attaching lids to the ring frame at each component region to seal the one or more electronic components attached to the respective component regions within the precursor.

10. The method of claim 9, wherein the method comprises testing the precursor for sealing leaks after the lids have been attached to the ring frame.

11. The method of claim 9 or 10, wherein the method comprises applying a marking to each lid to identify the one or more electronic components attached to the respective component region.

12. The method of claim 11, wherein the method comprises performing one or more of the lead attachment, wire attachment, sealing, marking, and leak testing steps before the precursor has been separated into the one or more discrete electronic component packages.

13. The method of claim 12, wherein the method comprises performing one or more of the component attachment, lead attachment, wire attachment, , sealing, marking and leak testing steps one component region at a time.

14. The method of claim 12, wherein the method comprises performing one or more of the component attachment, lead attachment, wire attachment, sealing, marking and leak testing steps on two or more component regions at the same time.

15. The method of claim 14, wherein the two or more component regions are spaced apart from each other.
